# NEUE EUROPÄISCHE PATENTSCHRIFT

(11) **EP 2 163 148 B2**
(45) Veröffentlichungstag und Bekanntmachung des Hinweises auf die Entscheidung über den Einspruch: **11.01.2017**
(45) Hinweis auf die Patenterteilung: 17.07.2013
(21) Anmeldenummer: 08759525.2
(22) Anmeldetag: 13.05.2008
(51) Int. Cl.: H05K 5/00, H05K 3/28, H05K 7/20, H05K 1/18

(54) **ELEKTRISCHES STEUERGERÄT**
ELECTRIC CONTROL DEVICE
UNITÉ DE COMMANDE ÉLECTRIQUE

(30) Priorität: 28.06.2007 DE 102007029913
(43) Veröffentlichungstag der Anmeldung: 17.03.2010
(60) Teilanmeldung: 10181790.6
(73) Patentinhaber: Robert Bosch GmbH, 70442 Stuttgart (DE)
(72) Erfinder: BECKER, Rolf, 72793 Pfullingen (DE); LAMMERS, Christian, 70499 Stuttgart (DE); JERG, Juergen, 72131 Ofterdingen (DE); WOLFF, Joachim, 72820 Sonnenbuehl (DE); HOCHHOLZER, Volker, 71292 Friolzheim (DE); TRESCHER, Ulrich, 72072 Tuebingen (DE); BUBECK, Helmut, 71717 Beilstein (DE); VOIGTLAENDER, Klaus, 73117 Wangen (DE); BENZLER, Jan, 72124 Pliezhausen (DE); RAICA, Thomas, 72379 Hechingen (DE); KUEHN, Willi, 71706 Markgroeningen (DE); WIESA, Thomas, 71665 Vaihingen (DE); KRAPP, Michael, 72770 Reutlingen (DE)
(86) Internationale Anmeldenummer: PCT/EP2008/055811
(87) Internationale Veröffentlichungsnummer: WO 2009/000594

(56) Entgegenhaltungen:
- DE-A1- 10 130 833
- DE-A1-102005 015 717
- DE-A1-102005 022 536
- US-A- 4 628 407

## Beschreibung

### Stand der Technik

Die Erfindung geht aus von einem elektrischen Steuergerät nach der Gattung des unabhängigen Anspruchs 1.

Ein derartiges Steuergerät ist beispielsweise aus der DE 40 23 319 C1 bekannt und weist ein Leiterbahnsubstrat in Form einer auf eine Platte auflaminierten flexiblen Leiterbahnfolie auf. Das Leiterbahnsubstrat ist beidseitig mit elektrischen Bauelementen bestückt, die eine elektronische Schaltung bilden. Die Bauelemente sind durch zwei auf der Oberseite und der Unterseite des Leiterbahnsubstrats aufgebrachte Gehäuseteile abgedeckt. Außerhalb des durch die Gehäuseteile abgedeckten Bereichs des Leiterbahnsubstrats ist ein Gerätestekkerteil auf dem Leiterbahnsubstrat angeordnet, das über Leiterbahnen des Leiterbahnsubstrats mit den Bauelementen verbunden ist und zum Anschluss des Steuergerätes an einen externen Kabelbaum dient. Das bekannte Steuergerät ist zum Einbau in den Motorraum eines Fahrzeuges bestimmt.

Ferner ist aus der DE 195 28 632 A1 ein Steuergerät bekannt, das ein mit elektrischen Bauelementen bestücktes Leiterbahnsubstrat aufweist, das auf der Oberseite und der Unterseite mit Gehäusehalbschalen abgedeckt ist. Die Halbschalen sind durch schraubbare Befestigungsmittel an dem Leiterbahnsubstrat befestigt. Ein auf das Leiterbahnsubstrat bestücktes Leistungsbauelement erzeugt im Betrieb Wärme, die über Durchkontaktierungen unter dem Leistungsbauelement auf eine wärmeleitende Schicht auf der Unterseite des Leiterbahnsubstrats und von dort auf ein damit in Kontakt stehendes Gehäuseteil abgeführt wird.

Außerdem ist aus der WO 2006/066983 ein als Steuermodul ausgebildetes elektrisches Steuergerät für ein Getriebe bekannt, bei dem ein Gerätestecker und ein Sensor an einem Träger angeordnet sind, deren elektrische Anschlüsse über eine flexible Leiterfolie in einen Gehäuseinnenraum geführt und dort über Drahtverbindungen mit einem separat hergestellten Schaltungsteil kontaktiert sind.

Aus der DE 101 30 833 A1 ist eine elektronische Steuerungsvorrichtung für ein Automatikgetriebe bekannt, welche eine Verbindungsisolationslage umfasst, in der Leiterbahnen in mehreren Lagen geführt sind. Eine elektronische Schaltung ist auf der Verbindungsisolationslage angeordnet und mit einem Gehäuseteil abgedeckt. Die Leiterbahnen der Verbindungsisolationslage verbinden die elektrischen Bauelemente der elektronischen Schaltung mit einem außerhalb des Gehäuseteils auf der Verbindungsisolationslage angeordneten Stekkerteil und mit wenigstens einer Kontaktstelle für eine weitere elektrische Komponente.

Aus der DE 10 2005 022 536 A1 ist eine Steuereinheit für ein Fahrzeuggetriebe bekannt, bei der Bauteile von einer starren Leiterplatte auf eine flexible Leiterplatte ausgelagert sind. Die flexible Leiterplatte ist durch ein Gehäuse hindurchgeführt, welches die starre Leiterplatte und einen Teil der flexiblen Leiterplatte aufnimmt.

### Offenbarung der Erfindung

### Vorteile der Erfindung

Das erfindungsgemäße elektrische Steuergerät mit den Merkmalen des unabhängigen Anspruchs 1 weist gegenüber den bekannten Steuergeräten den Vorteil auf, für den Anbau an ein Automatikgetriebe in besonders kostengünstiger und einfacher Herstellungsweise geeignet zu sein. Steuergeräte die in Automatikgetrieben verbaut werden, müssen neben dem Gerätestekker und einem elektronischen Schaltungsteil aus miteinander verbundenen elektrischen Bauelementen mit einer Vielzahl weiterer elektrischer Komponenten kontaktiert werden, wie beispielsweise Aktuatoren und/oder Sensoren. Das erfindungsgemäße Steuergerät weist vorteilhaft nur ein einziges gemeinsames Leiterbahnsubstrat auf. Hierbei kann es sich um eine Leiterplatte, eine flexible Leiterfolio auf einem Metallträger oder ein anderes geeignetes Leiterbahnsubstrat handeln. Wichtig ist, dass die Leiterbahnen des Leiterbahnsubstrats nicht nur zur elektrischen Verbindung derjenigen elektrischen Bauelemente dienen, die auf dem Leiterbahnsubstrat ein durch Gehäuseteile abgedecktes elektronisches Schaltungsteil bilden, sondern auch weitere Leiterbahnen, die zur Verbindung des Schaltungsteil mit einem Gerätesteckerteil und mit wenigstens einer Kontaktstelle für eine weitere elektrische Komponente dienen. Diese wenigstens eine Kontaktstelle ist außerhalb des durch das Gehäuseteil oder, falls mehrere Gehäuseteile vorgesehen sind, außerhalb des durch die Gehäuseteile abgedeckten Teils und außerhalb des mit dem Gerätestekkerteil versehenen Teils des Leiterbahnsubstrats angeordnet.

Die wenigstens eine Kontaktstelle kann vorteilhaft mit einem auf das Leiterbahnsubstrat aufgebrachten Sensoranschlussteil elektrisch verbunden sein. Darüber hinaus ist es möglich, wenigstens eine Kontaktstelle auf dem Leiterbahnsubstrat außerhalb des durch die Gehäuseteile abgedeckten Bereichs vorzusehen, die mit einem elektrohydraulischen Aktuator, beispielsweise einem elektrisch betätigbaren Druckregelventil, oder einem Gegenkontakt einer anderen Getriebekomponente elektrisch verbunden ist.

Erfindungsgemäß wird vorgeschlagen, die nicht durch das wenigstens eine Gehäuseteil und das Gerätesteckerteil und die wenigstens eine Kontaktstelle abgedeckten äußeren Bereiche des Leiterbahnsubstrats mit einer Schutzbeschichtung zu versehen. Ein plattenförmiges Leiterbahnsubstrat mit einer ersten Seite und einer von der ersten Seite abgewandte zweite Seite und einer umlaufenden Stirnseite umfasst vorteilhaft als Schutzbeschichtung eine auf die erste Seite und die zweite Seite aufgebrachte Schutzschicht und eine auf die umlaufende Stirnseite aufgebrachte Kantenabdekkung. Die Schutzbeschichtung kann eine Kupferschicht, eine Lackierung oder andere geeignete Passivierungsschicht umfasst, die eine Diffusion von Getriebeöl, Wasser und anderen schädlichen Medien in das Substrat vorteilhaft verhindert.

Vorteilhafte Ausbildungen und Weiterentwicklungen der Erfindung werden durch die in den abhängigen Ansprüchen angegebenen Maßnahmen ermöglicht.

Elektrische Komponenten, wie beispielsweise ein Sensoranschlussteil, können vorteilhaft außerhalb des durch die Gehäuseteile abgedeckten Bereichs des Leiterbahnsubstrats direkt auf diesem angeordnet sein. Andere Kontaktstellen auf dem Leiterbahnsubstrat außerhalb des durch die Gehäuseteile abgedeckten Bereichs können mit räumlich entfernt von dem Leiterbahnsubstrat angeordneten Aktuatoren elektrisch verbunden sein.

Zur Verbesserung der Wärmeabfuhr kann wenigstens ein Gehäuseteil mit einer ebenen Fläche zur Auflage auf einen zur Wärmeabfuhr vorgesehenen Kühlkörper, insbesondere eine Hydraulikplatte eines Kraftfahrzeuggetriebes, ausgebildet sein.

Eine weitere Verbesserung der Wärmeabfuhr resultiert daraus, dass wenigstens ein auf einer ersten Seite des Leiterbahnsubstrats angeordnetes, Wärme erzeugendes elektrisches Bauelement über Durchkontaktierungen des Leiterbahnsubstrats mit einer wärmeleitenden Schicht auf einer von der ersten Seite abgewandten zweiten Seite des Leiterbahnsubstrats thermisch verbunden ist. Zur weiteren Verbesserung der Wärmeableitung steht die wärmeleitende Schicht mit einem Gehäuseteil und/oder einem Kühlkörper in Wärmeleitkontakt.

### Kurze Beschreibung der Zeichnungen

Ausführungsbeispiele der Erfindung sind in den Zeichnungen dargestellt und werden in der nachfolgenden Beschreibung näher erläutert. Es zeigen
- Figur 1: einen Querschnitt durch ein auf eine Hydraulikplatte eines Getriebes montiertes erfindungsgemäßes elektrisches Steuergerät mit daran angeordneten Sensoren und Aktuatoren,
- Figur 2: eine Draufsicht auf das Leiterbahnsubstrat des Steuergeräts ohne Sensoren, Aktuatoren und Gehäuseteile,
- Figur 3: ein vergrößertes Detail aus Fig. 1,
- Figur 4: einen Detail eine Querschnitts des Leiterbahnsubstrats nach einem anderen Ausführungsbeispiel der Erfindung,
- Figur 5: einen Querschnitt durch ein weiteres Ausführungsbeispiel der Erfindung, wobei das Gerätesteckerteil der Einfachheit halber nicht dargestellt ist,
- Figur 6: ein Detail eines vierten Ausführungsbeispiels,
- Figur 7: ein Detail eines fünften Ausführungsbeispiels,
- Figur 8: ein Detail eines weiteren Ausführungsbeispiels.

### Ausführungsformen der Erfindung

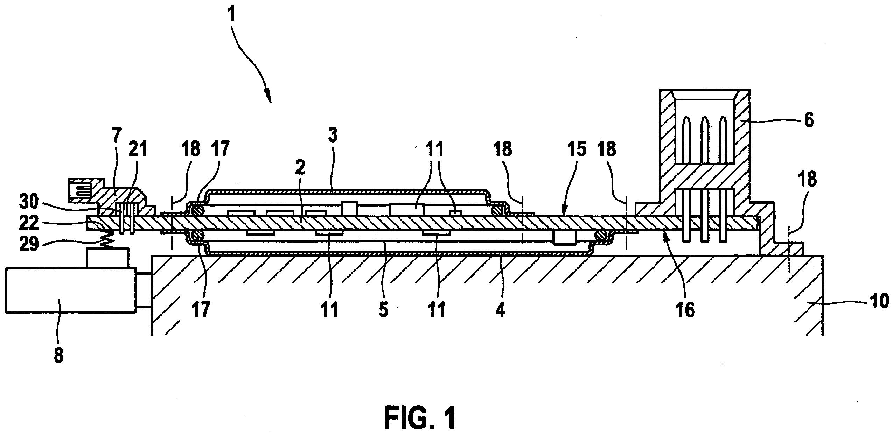

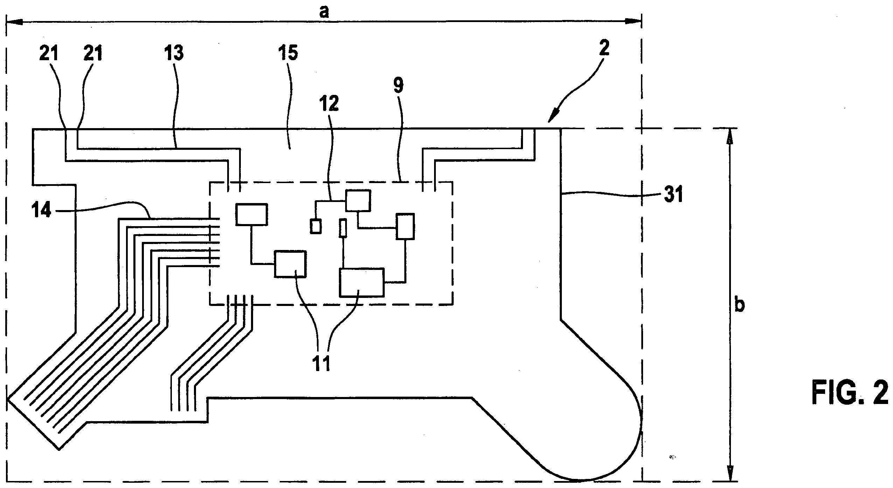

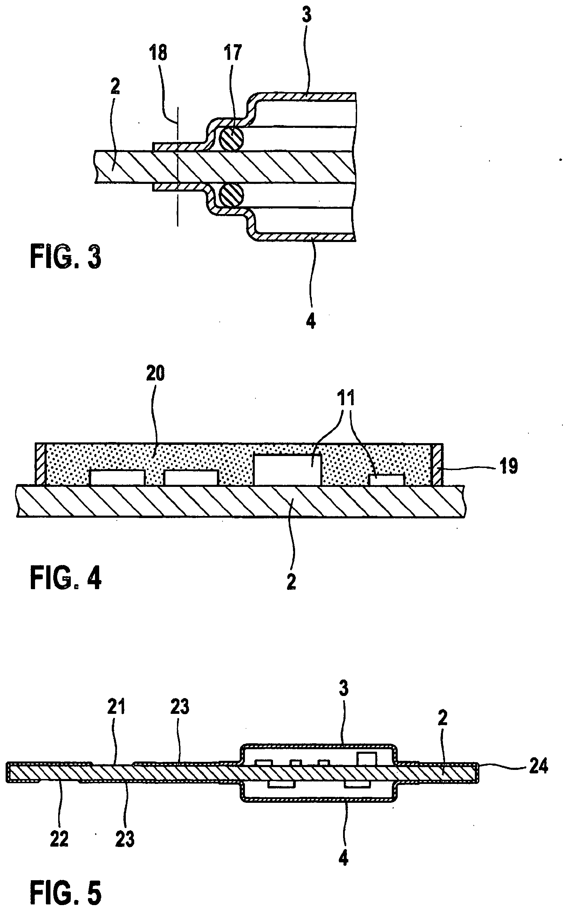

Figur 1 zeigt einen Querschnitt durch ein erstes Ausführungsbeispiel der Erfindung. Das erfindungsgemäße elektrische Steuergerät 1 umfasst ein Leiterbahnsubstrat 2. Dieses kann als Einlagenleiterplatte oder Mehrlagenleiterplatte oder als eine auf eine Metallplatte auflaminierte flexible Leiterfolie oder als Spritzgussteil mit darin eingebetteten Leiterbahnen oder in sonstiger Weise ausgebildet sein. Das Leiterbahnsubstrat ist im wesentlichen plattenförmig mit einer ersten Seite 15 und einer davon abgewandten zweiten Seite 16 und einer umlaufenden Stirnseite 31 ausgebildet. Auf der ersten Seite 15 und der zweiten Seite 16 ist das Leiterbahnsubstrat 2 in einem lokal begrenzten Bereich mit elektrischen Bauelementen 11 versehen, die eine elektronische Schaltung 9 bilden. Die Bauelemente 11 können natürlich auch nur auf einer Seite des Leiterbahnsubstrats aufgebracht sein. Der mit den Bauelementen 11 bestückte Bereich ist in Figur 2 durch die gestrichelte Linie gekennzeichnet. Die elektrischen Bauelemente 11 sind durch Leiterbahnen 12 des Leiterbahnsubstrats 2 elektrisch miteinander verbunden. Die Leiterbahnen können über eine oder mehrer Lagen des Mehrlagensubstrats geführt sein. Außer den Leiterbahnen 12 zur Verdrahtung der Bauelemente 11 sind weitere Leiterbahnen 13 und Leiterbahnen 14 auf dem Leiterbahnsubstrat angeordnet, die zu entlegenen Bereichen des Leiterbahnsubstrats 2 außerhalb des mit der elektronischen Schaltung 9 belegten Bereichs auf der ersten Seite 15 und der zweiten Seite 16 führen. Wie in Figur 2 zu erkennen ist, weist das Leiterbahnsubstrat eine maximale Länge a und eine maximale Breite b auf, die so bemessen sind, das möglichst wenig Materialverschnitt entsteht. Die Flächenausdehnung des Leiterbahnsubstrats 2 ist den Gegebenheiten in einem Kraftfahrzeuggetriebe angepasst. Wie in Figur 1 zu erkennen ist, sind die zur elektronischen Schaltung 9 gehörenden Bauelemente 11 auf der ersten Seite 15 mit einem Gehäuseteil 3 abgedeckt, während Bauelemente 11 auf der zweiten Seite 16 mit einem zweiten Gehäuseteil 4 abgedeckt sind. Die Gehäuseteile 3, 4 können beispielsweise als metallische Halbschalenteile, beispielsweise als Stanzbiegeteile ausgebildet sein. Wie am besten in Figur 3 zu erkennen ist, kann das erste Gehäuseteil 3 und das zweite Gehäuseteil 4 in bekannter Weise im Randbereich mehrfach abgewinkelt sein, so dass jeweils ein umlaufender Dichtring 17 zwischen dem abgewinkelten Bereich des jeweiligen Gehäuseteils und dem Leiterbahnsubstrat 2 angeordnet werden kann. Mittels Schraubverbindungen 18 oder in sonstiger geeigneter Weise kann das erste Gehäuseteil 3 und das zweite Gehäuseteil 4 an dem Leiterbahnsubstrat 2 befestigt werden, wobei der jeweilige umlaufende Dichtring 17 zwischen dem zugeordneten Gehäuseteil und dem Leiterbahnsubstrat 2 zusammengepresst und die elektronische Schaltung 9 nach außen abgedichtet wird.

Die Leiterbahnen 14 des Leiterbahnsubstrats 2 verbinden die elektrischen Bauelemente 11 mit einem Gerätesteckerteil 6, das außerhalb des durch die Gehäuseteile 3, 4 abgedeckten Bereichs auf dem Leiterbahnsubstrat angeordnet ist. Das Gerätesteckerteil 6 dient zum Anschluss des Steuergerätes 1 an einen externen Kabelbaum. Wichtig ist, dass außerhalb des durch die Gehäuseteile 3, 4 abgedeckten Bereichs und außerhalb des durch das Gerätesteckerteil 6 abgedeckten Bereichs auf dem Leiterbahnsubstrat 2 wenigstens eine Kontaktstelle 21 angeordnet ist, die zur Kontaktierung einer weiteren elektrischen Komponente des Steuergerätes dient. Die wenigstens eine Kontaktstelle 21 kann beispielsweise in Form einer metallisierten Fläche oder einer Durchkontaktierung ausgebildet sein.

Wie in Figur 1 gezeigt ist, kann es sich bei der weiteren Komponente beispielsweise um ein Sensoranschlussteil 7 handeln. Das Sensoranschlussteil 7 dient zum Anschluss an einen Drehzahlsensor und ist mittels zweier Kontaktstifte 30 mit zwei Kontaktstellen 21 auf dem Leiterbahnsubstrat elektrisch verbunden. Die Kontaktstellen 21 sind über Leiterbahnen 13 mit der elektronischen Schaltung 9 verbunden sind, wie dies in Figur 2 dargestellt ist. Das Sensoranschlussteil 7 kann mechanisch an dem Leiterbahnsubstrat 2 außerhalb des durch die Gehäuseteile 3, 4 und das Gerätesteckerteil abgedeckten Bereichs befestigt sein. Wie in Figur 1 weiterhin zu erkennen ist, ist auf der zweiten Seite des Leiterbahnsubstrats wenigstens eine weitere Kontaktstelle 22 angeordnet, die mittels eines elektrisch leitfähigen Federkontaktelementes 29 mit einem elektrohydraulischen Aktuator verbunden ist. Der elektrohydraulische Aktuator 8 kann beispielsweise ein Druckregelventil sein, das den Hydraulikdruck in einer Hydraulikleitung des Getriebes reguliert. Auf dem Leiterbahnsubstrat 2 können außerhalb der durch die Gehäuseteile 3, 4 und das Gerätesteckerteil 6 abgedeckten Bereiche beliebig viele andere Kontaktstellen zur Kontaktierung von elektrischen Komponenten des Getriebes, wie beispielsweise Sensoren, Aktuatoren, Klemmkontakten und Andrückkontakten angeordnet sein. Die Kontaktierung der Kontaktstellen mit den elektrischen Komponenten kann mittels Steckkontakten, Lötkontakten, Einpresskontakten, Federkontakten oder in sonstiger geeigneter Weise erfolgen. Alle Kontaktstellen sind über Leiterbahnen des Leiterbahnsubstrats mit der elektronischen Schaltung 9 verbunden.

Das mit den Gehäuseteilen 3, 4, dem Gerätesteckerteil 6 und den Kontaktstellen 21, 22 und gegebenenfalls elektrischen Komponenten 7 bestückte Leiterbahnsubstrat 2 ist mit einer ebenen Außenfläche des zweiten Gehäuseteils 4 auf einen Kühlkörper 10 montiert, bei dem es sich beispielsweise um die Hydraulikplatte eines Getriebes handeln kann. An der Hydraulikplatte sind mehrere Aktuatoren 8 befestigt, welche über Federkontaktelemente 29 mit zugeordneten Kontaktstellen 22 auf dem Leiterbahnsubstrat elektrische verbunden sind.

Wie in Figur 4 dargestellt ist, kann anstelle des beispielweise halbschalenförmigen Gehäuseteils 3 oder 4 auch ein mit einer Vergussmasse 20 gefülltes Rahmenteil 19 als Gehäuseteil zur Abdeckung der elektrischen Bauelemente 11 verwandt werden. Es ist aber auch möglich, die die Bauelemente 11 abdeckenden Gehäuseteile durch Moldmassen, Schäume, Gele oder in sonstiger Weise auszubilden. Wichtig ist, dass die Bauelemente 11 auf der ersten Seite 15 und die Bauelemente 11 auf der zweiten Seite 16 durch die Gehäuseteile 3, 4 vor aggressiven Medien geschützt sind.

Ein besonders bevorzugtes Ausführungsbeispiel der Erfindung ist in Figur 5 dargestellt. Dieses Ausführungsbeispiel unterscheidet sich von dem in Figur 1 dargestellten Ausführungsbeispiel dadurch, dass die nicht durch die Gehäuseteile 3, 4 abgedeckten Bereiche auf der ersten Seite 15 und der zweiten Seite 16 des Leiterbahnsubstrats 2 mit einer Schutzbeschichtung versehen sind. Hierzu ist die erste Seite 15 und die von der ersten Seite abgewandte zweite Seite 16 des Leiterbahnsubstrats 2 bis auf die mit dem nicht dargestellten Gerätesteckerteil 6, die Gehäuseteile 3, 4 und die Kontaktstellen 21, 22 belegten äußeren Bereiche mit jeweils einer großflächig aufgetragenen Schutzschicht 23 versehen. Die Schutzschicht 23 umfasst vorzugsweise eine großflächige Kupferleiterbahn, eine Lackierung oder eine geeignete harte oder weiche Beschichtung, welche die Diffusion von Medien wie z.B. Getriebeöl oder feuchter Luft in das Substrat verhindert. Auf die umlaufende Stirnseite des Leiterbahnsubstrats 2 ist als Schutzbeschichtung eine Kantenabdeckung 24 aufgebracht. Die Kantenabdeckung 24 kann durch Lacke, Moldmassen, Umspritzung oder eine andere geeignete Passivierung realisiert sein.

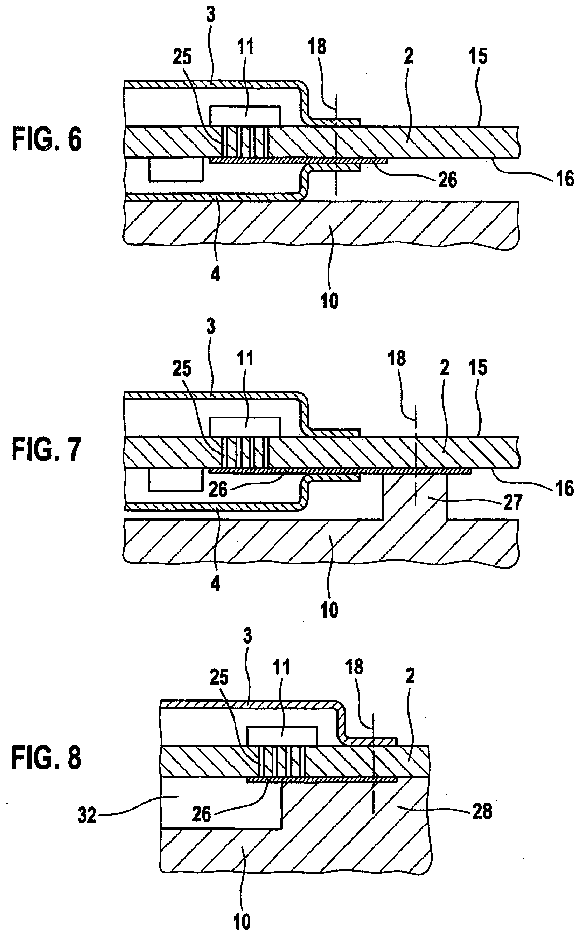

Die Wärmeabfuhr von Wärme erzeugenden Bauelementen 11 kann in verschiedener Weise vorgenommen werden. Wie in Fig. 6 dargestellt, kann die von Leistungsbauelementen 11 auf der ersten Seite 15 des Leiterbahnsubstrats 2 erzeugte Wärme beispielsweise in an sich bekannter Weise über in dem Leiterbahnsubstrat vorgesehene Durchkontaktierungen 25 auf die zweite Seite 16 abgeführt werden. Die zweite Seite 16 des Leiterbahnsubstrats 2 steht mit einer wänneleitenden Schicht 26 in thermischen Kontakt. Die wänneleitende Schicht 26 kann beispielsweise eine Kupferschicht sein, welche die Wärme auf das damit in Wärmeleitkontakt stehendes Gehäuseteil 4 überträgt. Von dort fließt die Wärme auf einen Kühlkörper 10 ab, auf dem das Gehäuseteil 4 aufliegt und der beispielsweise eine Hydraulikplatte des Getriebes darstellt. Die Wärme kann aber auch unmittelbar von der wärmeleitenden Schicht 26 auf den Kühlkörper 10 übertragen werden. Zu diesem Zweck kann, wie in Figur 7 dargestellt, der Kühlkörper mit einem Podest 27 versehen sein, auf dem das Leiterbahnsubstrat 2 unter Zwischenschaltung der wärmeleitenden Schicht 26 aufliegt. Alternativ kann, wie in Figur 8 dargestellt ist, der Kühlkörper 10 auch eine Aussparung 32 und einen die Aussparung 32 umgebenden Rand 28 aufweisen, auf den das Leiterbahnsubstrat 2 unter Zwischenlage der wärmeleitenden Schicht 26 aufliegt.

## Patentansprüche

1. Getriebesteuermodul (1) mit einem Leiterbahnsubstrat (2) auf dem eine elektronische Schaltung (9) angeordnet ist, die mehrere über Leiterbahnen (12, 13, 14) des Leiterbahnsubstrats untereinander verbundene elektrische Bauelemente (11) umfasst, mit wenigstens einem Gehäuseteil (3, 4) zur Abdeckung der elektrischen Bauelemente (11) auf dem Leiterbahnsubstrat und mit wenigstens einem elektrisch mit den Bauelementen verbundenen Gerätesteckerteil (6), das außerhalb des durch das wenigstens eine Gehäuseteil (3, 4) abgedeckten Teils des Leiterbahnsubstrats (2) auf diesem angeordnet ist, wobei die elektrischen Verbindungen zwischen den Bauelementen und dem Gerätesteckerteil durch Leiterbahnen (14) des Leiterbahnsubstrats erfolgt und wenigstens eine Kontaktstelle (21, 22) für eine weitere elektrische Komponente (7, 8) außerhalb des durch das wenigstens eine Gehäuseteil (3, 4) abgedeckten Teils des Leiterbahnsubstrats (2) und außerhalb des mit dem Gerätesteckerteil (6) versehenen Teils des Leiterbahnsubstrats (2) auf diesem angeordnet ist, und wobei das Leiterbahnsubstrat (2) eine Mehrlagenleiterplatte ist, deren Leiterbahnen (14) über mehrere Lagen geführt sind, wobei die nicht durch das wenigstens eine Gehäuseteil (3, 4) und das Gerätesteckerteil (6) und die wenigstens eine Kontaktstelle (21, 22) abgedeckten äußeren Bereiche der Mehrlagenleiterplatte (2) mit einer Schutzbeschichtung (23, 24) zur Verhinderung von Diffusion von Getriebeöl, Wasser und anderen schädlichen Medien versehen sind und die Mehrlagenleiterplatte plattenförmig mit einer ersten Seite (15) und einer von der ersten Seite abgewandte zweite Seite (16) und einer umlaufenden Stirnseite (31) ausgebildet ist, **dadurch gekennzeichnet, dass** die Schutzbeschichtung (23, 24) eine auf die erste Seite und die zweite Seite aufgebrachte Schutzschicht (23) und eine auf die umlaufende Stirnseite aufgebrachte Kantenabdeckung (24) umfasst.

2. Getriebesteuermodul (1) nach Anspruch 1, **dadurch gekennzeichnet, dass** die weitere elektrische Komponente (7) auf der Mehrlagenleiterplatte (2) angeordnet ist.

3. Getriebesteuermodul (1) nach Anspruch 1, **dadurch gekennzeichnet, dass** die Schutzbeschichtung (23, 24) eine Kupferschicht, eine Lackierung oder andere geeignete Passivierungsschicht umfasst.

4. Getriebesteuermodul (1) nach Anspruch 1, **dadurch gekennzeichnet, dass** die wenigstens eine Kontaktstelle (21) mit einem auf der Mehrlagenleiterplatte (2) aufgebrachten Sensoranschlussteil (7) elektrisch verbunden ist oder dass die wenigstens eine Kontaktstelle (22) mit einem elektrohydraulischen Aktuator (8) elektrisch verbunden ist.

5. Getriebesteuermodul (1) nach Anspruch 1, **dadurch gekennzeichnet, dass** wenigstens ein Gehäuseteil (4) mit einer ebenen Fläche zur Auflage auf einen zur Wärmeabfuhr vorgesehenen Kühlkörper (10), insbesondere eine Hydraulikplatte eines Kraftfahrzeuggetriebes, ausgebildet ist.

6. Getriebesteuermodul (1) nach Anspruch 1, **dadurch gekennzeichnet, dass** wenigstens ein auf einer ersten Seite (15) des Leiterbahnsubstrats (2) angeordnetes, Wärme erzeugendes elektrisches Bauelement (11) über Durchkontaktierungen (25) des Leiterbahnsubstrats (2) mit einer wärmeleitenden Schicht (26) auf einer von der ersten Seite abgewandten zweiten Seite (16) des Leiterbahnsubstrats thermisch verbunden ist.

7. Getriebesteuermodul (1) nach Anspruch 6, **dadurch gekennzeichnet, dass** die wärmeleitende Schicht (26) mit einem Gehäuseteil (3, 4) und/oder einem Kühlkörper (10) in Wärmeleitkontakt steht.

## Claims

1. Transmission control module (1) having a conductor track substrate (2) on which an electronic circuit (9) is arranged, the said electronic circuit comprising a plurality of electrical components (11) which are connected to one another by means of conductor tracks (12, 13, 14) of the conductor track substrate, having at least one housing part (3, 4) for covering the electrical components (11) on the conductor track substrate, and having at least one device plug part (6) which is electrically connected to the components and which is arranged on the conductor track substrate (2) outside that part of the said conductor track substrate which is covered by the at least one housing part (3, 4), wherein the electrical connections between the components and the device plug part are made by conductor tracks (14) of the conductor track substrate, and at least one contact point (21, 22) for a further electrical component (7, 8) is arranged on the conductor track substrate (2) outside that part of the said conductor track substrate which is covered by the at least one housing part (3, 4) and outside that part of the said conductor track substrate (2) which is provided with the device plug part (6), and wherein the conductor track substrate (2) is a multilayered printed circuit board of which the conductor tracks (14) are routed over a plurality of layers, wherein the outer regions of the multilayered printed circuit board (2) which are covered by the at least one housing part (3, 4) and the device plug part (6) and the at least one contact point (21, 22) are provided with a protective coating (23, 24) for preventing diffusion of transmission oil, water and other harmful media, and the multilayered printed circuit board is designed in the form of a plate with a first face (15) and a second face (16), which is averted from the first face, and a circumferential end face (31), **characterized in that** the protective coating (23, 24) comprises a protective layer (23) which is applied to the first face and the second face and comprises an edge cover (24) which is applied to the circumferential end face.

2. Transmission control module (1) according to Claim 1, **characterized in that** the further electrical component (7) is arranged on the multilayered printed circuit board (2).

3. Transmission control module (1) according to Claim 1, **characterized in that** the protective coating (23, 24) comprises a copper layer, a coating or another suitable passivation layer.

4. Transmission control module (1) according to Claim 1, **characterized in that** the at least one contact point (21) is electrically connected to a sensor connection part (7) which is mounted on the multilayered printed circuit board (2), or **in that** the at least one contact point (22) is electrically connected to an electrohydraulic actuator (8).

5. Transmission control module (1) according to Claim 1, **characterized in that** at least one housing part (4) is designed with a flat surface for bearing on a heat sink (10) which is provided for dissipating heat, in particular a hydraulic plate of a motor vehicle transmission.

6. Transmission control module (1) according to Claim 1, **characterized in that** at least one heat-generating electrical component (11) which is arranged on a first face (15) of the conductor track substrate (2) is thermally connected to a heat-conducting layer (26) on a second face (16), which is averted from the first face, of the conductor track substrate by means of plated-through holes (25) in the conductor track substrate (2).

7. Transmission control module (1) according to Claim 6, **characterized in that** the heat-conducting layer (26) is in thermal contact with a housing part (3, 4) and/or a heat sink (10).

## Revendications

1. Module (1) de commande de transmission, présentant
un substrat (2) de pistes conductrices sur lequel est disposé un circuit électronique (9) qui comporte plusieurs composants électriques (11) reliés les uns aux autres par des pistes conductrices (12, 13, 14) du substrat de pistes conductrices,
au moins une partie (3, 4) de boîtier qui recouvre les composants électriques (11) placés sur le substrat de pistes conductrices et
au moins une partie (6) de fiche d'appareil reliée électriquement aux composants et disposée sur le substrat (2) de pistes conductrices à l'extérieur de la partie du substrat de pistes conductrices recouverte par la ou les parties (3, 4) de boîtier,
les liaisons électriques entre les composants et la partie de fiche d'appareil s'effectuant par des pistes conductrices (14) du substrat de pistes conductrices et au moins un emplacement de contact (21, 22) prévu pour un autre composant électrique (7, 8) étant disposé sur le substrat (2) de pistes conductrices à l'extérieur de la partie du substrat de pistes conductrices recouverte par la ou les parties (3, 4) de boîtier et à l'extérieur de la partie du substrat (2) de pistes conductrices dotée de la partie (6) de fiche d'appareil,
le substrat (2) de pistes conductrices étant une carte de circuit multicouche dont les pistes conductrices (14) traversent plusieurs couches des parties extérieures non recouvertes par la ou les parties (3, 4) de boîtier et la partie (6) de fiche d'appareil et le ou les emplacements de contact (21, 22) de la carte (2) de circuit multicouche étant dotés d'un revêtement protecteur (23, 24) qui empêche la diffusion d'huile de transmission, d'eau et d'autres fluides nocifs,
la carte de circuit multicouche présentant la forme d'une plaque dotée d'une première face (15) et d'une deuxième face (16) non tournée vers la première face ainsi que d'un côté frontal périphérique (31), **caractérisé en ce que**
le revêtement de protection (23, 24) comporte une couche de protection (23) appliquée sur la première face et la deuxième face et un recouvrement de champ (24) appliqué sur le côté frontal périphérique.

2. Module (1) de commande de transmission selon la revendication 1, **caractérisé en ce que** l'autre composant électrique (7) est disposé sur la carte (2) de circuit multicouche.

3. Module (1) de commande de transmission selon la revendication 1, **caractérisé en ce que** le revêtement de protection (23, 24) comporte une couche de cuivre, un vernis ou une autre couche de passivation appropriée.

4. Module (1) de commande de transmission selon la revendication 1, **caractérisé en ce que** le ou les emplacements de contact (21) sont reliés électriquement à une pièce (7) de raccordement de détecteur appliquée sur la carte (2) de circuit multicouche ou **en ce que** le ou les emplacements de contact (22) sont reliés électriquement à un actionneur électrohydraulique (8).

5. Module (1) de commande de transmission selon la revendication 1, **caractérisé en ce qu'**au moins une partie (4) de boîtier est configurée avec une surface destinée à être posée sur un corps de refroidissement (10) prévu pour évacuer la chaleur, en particulier sur une plaque hydraulique d'une transmission de véhicule automobile.

6. Module (1) de commande de transmission selon la revendication 1, **caractérisé en ce qu'**au moins un composant électrique (11) disposé sur une autre face (15) du substrat (2) de pistes conductrices et dégageant de la chaleur est relié thermiquement par des perforations de contact (25) du substrat (2) de pistes conductrices à une couche (26) conduisant la chaleur située sur une deuxième face (16) du substrat de pistes conductrices non tournée vers la première face.

7. Module (1) de commande de transmission selon la revendication 6, **caractérisé en ce que** la couche (26) thermiquement conductrice est en contact de conduction thermique avec une partie (3, 4) de boîtier et/ou avec un corps de refroidissement (10).
